Europäisches Patentamt

European Patent Office

Office européen des brevets

(19)

(11) Publication number: **0 116 397**
**B1**

(12) **EUROPEAN PATENT SPECIFICATION**

(45) Date of publication of patent specification: **18.05.88**

(21) Application number: **84300075.3**

(22) Date of filing: **05.01.84**

(51) Int. Cl.⁴: **G 01 R 19/165,**
**H 03 K 19/094**

(54) **Voltage responsive circuit.**

(30) Priority: **26.01.83 GB 8302113**

(43) Date of publication of application:
**22.08.84 Bulletin 84/34**

(45) Publication of the grant of the patent:
**18.05.88 Bulletin 88/20**

(84) Designated Contracting States:
**DE FR GB IT NL**

(56) References cited:
**DE-A-3 038 409**
**US-A-4 259 729**
**US-A-4 322 639**

(73) Proprietor: **STC PLC**
**10, Maltravers Street**
**London, WC2R 3HA (GB)**

(72) Inventor: **Monk, Trevor Kenneth**
**134 The Drive**
**Bexley Kent (GB)**

(74) Representative: **Dennis, Mark Charles**
**STC Patent Department Edinburgh Way**
**Harlow Essex CM20 2SH (GB)**

Courier Press, Leamington Spa, England.

## Description

This invention relates to voltage responsive circuits and is particularly, but not exclusively, applicable to overvoltage detector circuits for integrated circuits.

Prior art document US—A—4 322 639 describes a voltage detection circuit using a voltage divider and MIS FET's and DE—A—3 038 409 describes a circuit comprising a capacitor connected in series to the source-drain path of a MOS transistor.

According to the present invention there is provided a voltage responsive circuit including a first capacitor, one terminal of which is connected to a first circuit terminal via the source-drain path of a first insulated gate field-effect transistor, and the other terminal of which first capacitor is connected to a second circuit terminal, characterised in that in use an input voltage to be compared with a voltage applied to the first circuit terminal is applied to the gate of the first transistor, the impedance available at the second terminal varying in dependence on whether the input voltage is higher or lower than the voltage applied to the first circuit terminal.

In one arrangement an a.c. signal is applied to the other terminal of the capacitor and a detector employed to determine whether the impedance available at the second circuit terminal is of a low value corresponding to the input voltage being greater than the voltage applied to the first circuit terminal plus the threshold voltage of the first transistor, or of a higher than the low value corresponding to the input voltage being lower than the voltage applied to the first circuit terminal plus the threshold voltage.

In another arrangement capacitor charging current impedance detection, with two non-time-overlapping clock signals, is employed.

In a further arrangement, which has a faster response time than the two above-referred-to arrangements, three clock signals are employed.

Embodiments of the invention will now be described with reference to the accompanying drawings, in which:—

Fig. 1 shows a basic circuit diagram;

Fig. 2 shows voltage time variations of the circuit of Fig. 1;

Fig. 3 shows a version of the basic circuit of Fig. 1 which uses a resistive impedance detector;

Fig. 4 shows a version of the basic circuit of Fig. 1 which uses a charging current impedance detector;

Fig. 5 shows the clock signals required for the Fig. 4 circuit;

Fig. 6 shows a clocked circuit version of the basic circuit of Fig. 1; and

Fig. 7 shows the clock signals and output for the Fig. 6 circuit.

A second function (upper case) facility on integrated circuit inputs is sometimes desirable, particularly at testing. For example, it may be required to detect when input voltages are greater than the positive supply rail ($V_{cc}$) and thus outside normal specified operating conditions.

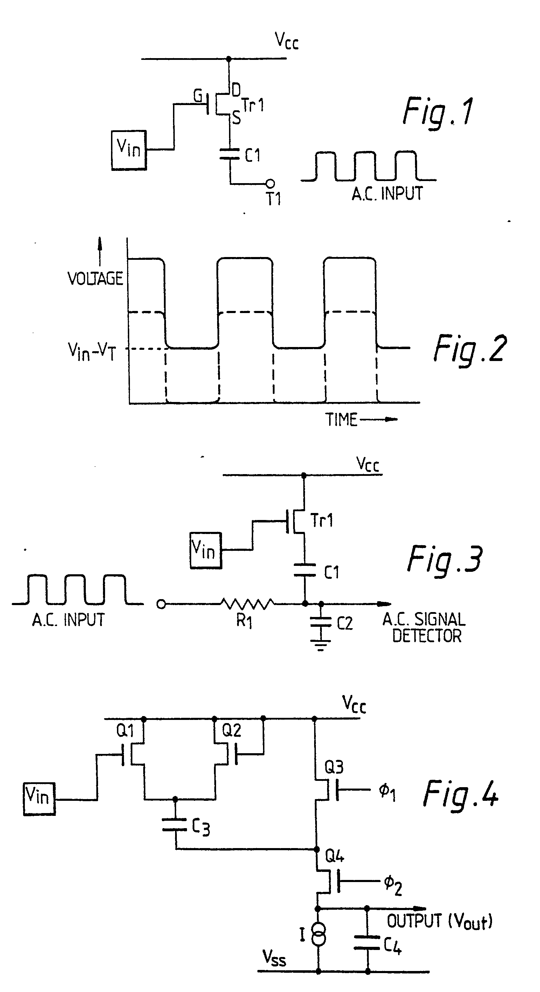

The basic circuit shown in Fig. 1 comprises an NMOS detector for detecting inputs $V_{in}$ greater than the positive supply rail $V_{cc}$. The circuit comprises a transistor-capacitor combination. An NMOS transistor Tr1 has its drain D connected to the $V_{cc}$ supply rail, and its source S connected to one plate, hereinafter referred to as the top plate, of a capacitor C1 whose other plate is connected to a terminal T1 to which an a.c. signal is applied. The input voltage $V_{in}$ to be compared with $V_{cc}$ is applied to the gate G of transistor Tr1. The capacitor C1 is designed to be of low impedance at the frequency of the a.c. signal.

If $V_{in} < V_{cc} + V_T$, where $V_T$ is the threshold voltage of transistor Tr1, the transistor will only conduct in the source-follower mode. The capacitor C1 will charge until the top plate is at a minimum voltage of $V_{in} - V_T$, see Fig. 2 in which the dashed line represents the applied a.c. signal and the solid line the top plate voltage. Once charged no further current can flow through the capacitor as the transistor gate voltage ($V_{in}$) is insufficient to turn the transistor Tr1 on. Terminal T1 then appears high impedance to the a.c. signal.

If, however, $V_{in} > V_{cc} + V_T$, then the transistor Tr1 has enough gate drive to conduct for any value of $V_{DS}$. The capacitor receives charge current, and supplies discharge current, through the transistor. Terminal T1 is then low impedance to the a.c. signal. The actual impedance is governed by the series combination of capacitor and channel conduction at a given $V_{in}$.

Thus, if some means of a.c. impedance detection is applied to terminal T1, then a $> V_{cc} + V_T$ detector is effected. Using an enhancement mode transistor allows this circuit to detect input signals greater than $V_{cc}$.

Fig. 3 illustrates the circuit of an embodiment using a resistive impedance detector. The a.c. signal, having a frequency $f$, is applied to the bottom plate of capacitor C1 via a resistor R1. "C2 represents stray circuit capacitances associated with the bottom plate of capacitor C1". For values of $V_{in} < V_{cc} + V_T$, the transistor Tr1 is high impedance. The attenuation of the a.c. signal is determined by $\omega R.C_{stray}$, where $\omega = 2\pi f$, R is the resistance value of resistor R1 and $C_{stray}$ is the capacitance value of a capacitor C2, and for negligible attenuation R is chosen to be $<< 1/(\omega C_{stray})$.

For values of $V_{in} > V_{cc} + V_T$ the transistor Tr1 conducts. If the capacitance value C of capacitor C1 is chosen such that $C >> 1/(R.\omega)$, then the attenuation of the a.c. signal is controlled by the ratio of R to the effective channel resistance of the transistor. The transistor dimensions are thus chosen so that for an appropriate $V_{in} > V_{cc} + V_T$ there is a large signal attenuation, for example greater than 20dB.

Thus if the magnitude of the signal applied to the a.c. signal detector is large, $V_{in} < V_{cc} + V_T$, whereas if the magnitude is small, $V_{in} > V_{cc} + V_T$.

Almost any input waveform with a large component at the fundamental frequency, for example sine, square, triangular, may be used with the circuit of Fig. 3.

Fig. 4 illustrates the circuit of an embodiment using a charging current impedance detector. The circuit comprises four enhancement mode NMOS transistors Q1, Q2, Q3 and Q4, two capacitors C3 and C4 and a current source I. The circuit employs non-overlapping clock signals $\phi_1$ and $\phi_2$ having a repetition frequency $f$. Q1 to Q4 are assumed to have identical threshold voltages, $V_T$, in this example, although this is not necessary for correct circuit operation.

If $V_{in}<V_{cc}$ initially, then C3 is charged to $V_{cc}-V_T$, via Q1/Q2, Q4 and I during period P2 of successive clock cycles. This is assumed as the starting condition in the following analysis.

If $V_{in}<V_{cc}+V_T$, during period P1 the top plate of C3 is floating; the bottom plate of C3 is held at $V_{cc}-V_T$ by Q3, thus the top plate is at $2V_{cc}-2V_T$; and Q1 is off so that C3 is not discharged. During period P2, C3 is still charged to $V_{cc}-V_T$ so that no current flows through Q1/Q2, Q4 and I. Hence the output $V_{out}=0$.

If, however, $V_{in}>V_{cc}+V_T$, then during period P1 transistor Q1 will conduct and partially discharge C3, whereupon during period P2 a current, greater than I, now flows through Q1/Q2, Q4, I/C4 to recharge C3. This partially charges C4. So $V_{out}>0$. With suitable choice of $f$, I and the capacitance values $C_3$ and $C_4$ of capacitors C3 and C4, then capacitor C4 will pump up to give a steady state output voltage.

Assuming ideal components and that capacitor C4 does not fully discharge via I between pumps, charge analysis of the circuit yields

$$V'_{out}=V_{cc}-V_T-I/(f.C_3)$$

as the steady state output voltage, where $V'_{out}$ is $V_{out}$ at the instant when $\phi_2$ goes low.

Capacitor C4 controls the amount of ripple on the output and the response time of the detector. Further analysis yields the relationship

$$n.I=f. (V'out.(C_3+C_4)-V_T.C_3)$$

where $n$ is the number of clock cycles taken for $V_{out}$ to recover from $V'_{out}$ to 0 volts when $V_{in}$ changes to $<V_{cc}+V_T$. A value of n=10 gives an acceptable compromise between ripple and response time for many applications. In the embodiment of Fig. 4, therefore, an input voltage greater than $V_{cc}+V_T$ results in the existence of an output voltage ($V_{out}>0$) and when $V_{in}<V_{cc}+V_T$ there is no output voltage ($V_{out}=0$).

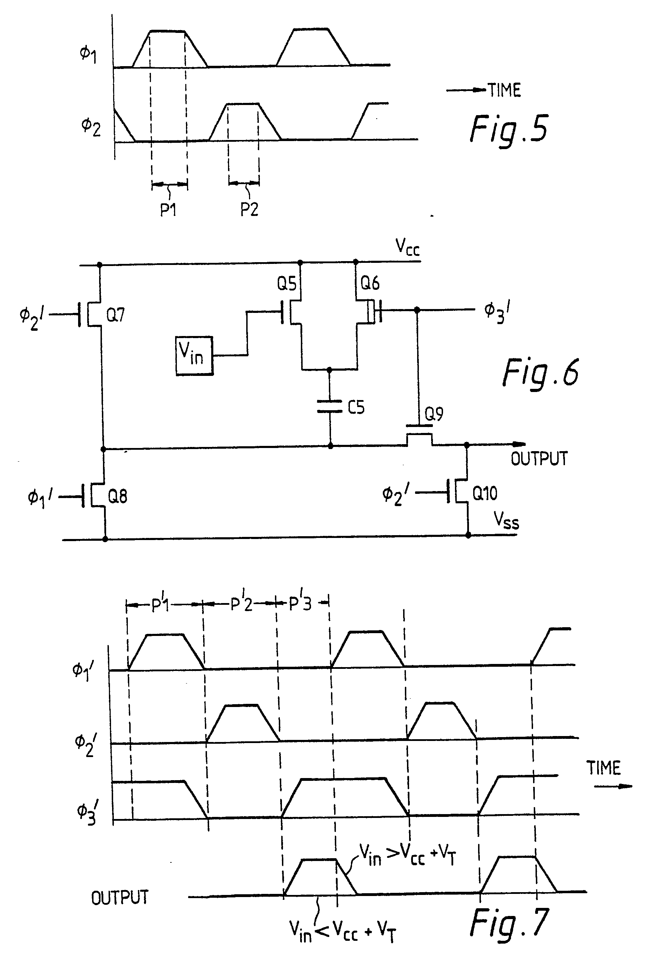

Fig. 6 shows a clocked circuit for detecting input levels $>V_{cc}+V_T$. It comprises six NMOS transistors Q5, Q6, Q7, Q8, Q9 and Q10 and a capacitor C5. Transistor Q6 is a depletion mode device whereas Q5 and Q7 to Q10 are enhancement mode devices. All the enhancement thresholds are here assumed to be equal to the value $V_T$, although this is not necessary for correct circuit operation. The three clock signals $\phi_1'$, $\phi_2'$, $\phi_3'$ employed in the circuit of Fig. 6 all have logic levels of either 0 volts or $V_{cc}$, and timing as shown in Fig. 7.

Referring to Fig. 7, within each clock cycle, the timing relationships generate three distinct periods, P'1, P'2, P'3, corresponding to precharge, sensing, and output circuit functions respectively.

Considering the circuit operation in more detail: during precharge period P'1, $\phi_1'$ and $\phi_3'$ are high so C5 is charged to $V_{cc}$ via Q6 and Q8. $\phi_1'$ and $\phi_3'$ go low at the end of period P'1 before $\phi_2'$ goes high to initiate the sensing period P'2. Q7 now pulls the bottom plate of C5 to $V_{cc}-V_T$, thus bootstrapping the top plate to $2V_{cc}-V_T$. If $V_{in}<V_{cc}+V_T$, Q5 does not conduct and so C5 retains its charge. If $V_{in}>V_{cc}+V_T$ then C5 is partially discharged through Q5. The sensing period is terminated when $\phi_2'$ goes low. $\phi_3'$ now goes high to start the output period P'3. The top plate of C5 is clamped to $V_{cc}$ by Q6. If C5 was not discharged during P'2, the bottom plate is at 0 volts. Otherwise the bottom plate is at $>0$ volts. Transistors Q9 and Q10 gate the bottom plate voltage to the output.

So if $V_{in}<V_{cc}+V_T$ during period P'2 the output is 0 volts, whereas if $V_{in}>V_{cc}+V_T$ during P'2 the output is greater than 0 volts. With idealised components and operating conditions C5 will be discharged to $V_T$ during period P'2, so that the output voltage in period P'3 is $V_{cc}-V_T$.

The output pulse may be gated by a suitable clock into a latch or sample and hold circuit to provide a continuously available indication of the input state.

The circuit of Fig. 6 has a very fast response time to a change in input level in comparison to the circuits of Figs. 3 and 4. With the clocked circuit of Fig. 6, the response time is controlled by the repetition period of the clocks. New data is available each cycle. The circuits of Figs. 3 and 4 use a data averaging technique and so require many cycles to produce a valid output signal.

It will be apparent that although all examples and descriptions given refer to NMOS circuits, the principles involved are easily applied to circuits fabricated in other MOS processes.

**Claims**

1. A voltage responsive circuit including a first capacitor (C1) one terminal of which is connected to a first circuit terminal ($V_{cc}$) via the source-drain path of a first insulated-gate-field-effect transistor (Tr1) and the other terminal of which first capacitor is connected to a second circuit terminal (T1), characterised in that in use an input voltage ($V_{in}$) to be compared with a voltage applied to the first circuit terminal ($V_{cc}$) is applied to the gate (G) of the first transistor (Tr1), the impedance available at the second circuit terminal (T1) varying in dependence on whether the input voltage ($V_{in}$) is higher or lower than the voltage applied to the first circuit terminal ($V_{cc}$).

2. A circuit as claimed in claim 1, characterised in that the first transistor (Tr1) is an enhancement mode MOS field effect transistor whose drain (D) is connected to the first circuit terminal ($V_{cc}$).

3. A circuit as claimed in claim 2, characterised in that in use an a.c. signal is applied to the other terminal of the capacitor, the circuit also including detector means for determining whether the impedance available at the second circuit terminal is of a low value corresponding to the input voltage ($V_{in}$) being greater than the voltage applied to the first circuit terminal ($V_{cc}$) plus the threshold voltage of the first transistor (Tr1) or of a higher than the low value corresponding to the input voltage ($V_{in}$) being lower than the voltage applied to the first circuit terminal ($V_{cc}$) plus the threshold voltage of the first transistor (Tr1).

4. A circuit as claimed in claim 3, characterised in that the a.c. signal is applied to the other terminal of the first capacitor via a resistor, wherein, a second capacitor (C2) is connected between the second circuit terminal (T1) and earth, and an a.c. signal detector is connected to the second circuit terminal (T1), the magnitude of the signal applied to the a.c. signal detector being higher for input voltage values less than the voltage applied to the first circuit terminal ($V_{cc}$) plus the threshold voltage of the first transistor (Tr1), than the magnitude of the signal for input voltage values greater than the voltage applied to the first circuit terminal plus the threshold voltage of the first transistor (Tr1).

5. A circuit as claimed in claim 2, characterised in that a second MOS transistor (Q2) is connected, to conduct in parallel with the first transistor, between the first circuit terminal ($V_{cc}$) and the one terminal of the first capacitor, the gate of the second transistor (Q2) being connected to the first circuit terminal ($V_{cc}$), that a third MOS transistor (Q3) is connected, so as to conduct between the first circuit terminal ($V_{cc}$) and the other terminal of the first capacitor, and is connected to conduct in series with a fourth MOS transistor (Q4) connected between the other terminal of the first capacitor and the second circuit terminal, in series to a current source (I), the second circuit terminal being connected between the fourth transistor (Q4) and the current source (I), that in use one clock pulse ($\phi_1$) is applied to the gate of the third transistor (Q3) and another clock pulse ($\phi_2$) is applied to the gate of the fourth transistor (Q4), which clock pulses are non-time overlapping, that the current source (I) is connected to a voltage supply ($V_{ss}$) and a third capacitor (C4) is connected in parallel with the current source, that the second, third and fourth transistors (Q2, Q3, Q4) are of the enhancement mode type, and that in use of the circuit there is an output voltage ($V_{out}$) at the second circuit terminal for values of the input voltage ($V_{in}$) greater than the voltage applied to the first circuit terminal ($V_{cc}$) plus the threshold voltage of the first transistor and there is no output voltage ($V_{out}$) at the second circuit terminal for values of the input voltage ($V_{in}$) less than the voltage applied to the first circuit terminal ($V_{cc}$) plus the threshold voltage of the first transistor.

6. A circuit as claimed in claim 2 and employing first, second and third clock signals, ($\phi'_3$, $\phi'_2$, $\phi'_1$)

characterised in that a fifth MOS transistor (Q6) is connected, to conduct in parallel with the first transistor, between the first circuit terminal ($V_{cc}$) and the one terminal of the capacitor, that the other terminal of the capacitor is connected to the second circuit terminal via the source-drain path of a sixth MOS transistor (Q9) whose gate is connected to the gate of the fifth transistor (Q6) and in use of the circuit the first clock signal ($\phi'_3$) being applied to the gates of the fifth and sixth transistors, that the second circuit terminal is connected to a voltage supply ($V_{ss}$) via the source-drain path of a seventh MOS transistor (Q10), that eighth and ninth MOS transistors (Q7, Q8) are connected in series between the first circuit terminal ($V_{cc}$) and the voltage supply ($V_{ss}$) that the other terminal of the first capacitor is connected to the junction between the eighth and ninth transistors (Q7, Q8), that the second clock signal ($\phi'_2$) is applied to the gates of the seventh and eight transistors (Q10, Q7), that the third clock signal ($\phi'_1$) is applied to the gate of the ninth transistor, (Q8) the fifth transistor (Q6) being of the depletion mode type and the seventh, eighth and ninth transistor (Q10, Q7, Q8) being of the enhancement mode type, the clock signals being such that the voltage at the second circuit terminal is zero during an output period (P'3) corresponding to a first clock signal pulse if, during the previous sensing period (P'2) corresponding to a second clock signal pulse, the input voltage ($V_{in}$) was less than the voltage applied to the first circuit terminal ($V_{cc}$) plus the threshold voltage of the first transistor, and is greater than zero during an output period (P'3) if, during the preceding sensing period P'2 the input voltage ($V_{in}$) was greater than the voltage applied to the first circuit terminal ($V_{cc}$) plus the threshold voltage of the first transistor.

7. A circuit as claimed in any one of the preceding claims and embodied in an integrated circuit, the first circuit terminal corresponding to the $V_{cc}$ rail thereof.

8. A circuit as claimed in claim 7 as appendant to claim 5 or claim 6, characterised in that the voltage supply corresponds to the $V_{ss}$ rail of the integrated circuit.

**Patentansprüche**

1. Spannungsempfindliche Schaltung mit einer ersten Kapazität (C1), deren einer Anschluß über die Source-Drain-Leitung eines ersten isolierten Gate-Feldeffekttransistors (Tr1) mit einem ersten Schaltungsanschluß ($V_{cc}$) verbunden ist, während der andere Anschluß der ersten Kapazität mit einem zweiten Schaltungsanschluß (T1) verbunden ist, dadurch gekennzeichnet, daß bei Benutzung eine mit einer am ersten Schaltungsanschluß ($V_{cc}$) anstehenden Spannung zu vergleichende Eingangsspannung ($V_{in}$) an das Gate (G) des ersten Transistors (Tr1) angelegt wird und daß die am zweiten Schaltungsanschluß (T1) verfügbare Impedanz in Abhängigkeit davon variiert, ob die Eingangsspannung ($V_{in}$) höher oder

niedriger als die Spannung am ersten Schaltungsanschluß (V<sub>cc</sub>) ist.

2. Schaltung nach Anspruch 1, dadurch gekennzeichnet, daß der erste Transistor (Tr1) ein Anreicherungs-MOS-Feldeffekttransistor ist, dessen Drain (D) mit dem ersten Schaltungsanschluß (V<sub>cc</sub>) verbunden ist.

3. Schaltung nach Anspruch 2, dadurch gekennzeichnet, daß bei Benutzung ein Wechselstromsignal an den anderen Anschluß der Kapazität gegeben wird und daß die Schaltung außerdem Detektormittel aufweist zur Ermittelung, ob die Impedanz des zweiten Schaltungsanschlusses einen niedrigen Wert aufweist korrespondierend zu der Eingangsspannung (V<sub>in</sub>), die größer ist als die am ersten Schaltungsanschluß (V<sub>cc</sub>) angelegte Spannung plus die Schwellenspannung des ersten Transistors (Tr1), oder ob sie einen höheren als den niedrigen Wert aufweist, korrespondierend zu der Eingangsspannung (V<sub>in</sub>), die niedriger ist als die am ersten Schaltungsanschluß (V<sub>cc</sub>) anliegende Spannung plus der Schwellenspannung des ersten Transistors (Tr1).

4. Schaltung nach Anspruch 3, dadurch gekennzeichnet, daß das Wechselstromsignal an den anderen Anschluß der ersten Kapazität über einen Widerstand angelegt wird, wobei eine zweite Kapazität (C2) zwischen den zweiten Schaltungsanschluß (T1) und Erde geschaltet ist und wobei ein Wechselstromsignal-Detektor mit dem zweiten Schaltungsanschluß (T1) verbunden ist und die Größe des dem Wechselstrom-Signal-Detektor zugeführten Signals höher ist, wenn die Eingangsspannungswerte niedriger liegen als die an den ersten Schaltungsanschluß (V<sub>cc</sub>) angelegte Spannung plus die Schwellenspannung des ersten Transistors (Tr1), als die Signal-größe, wenn die Eingangsspannungswerte größer sind als die an den ersten Schaltungsanschluß angelegte Spannung plus die Schwellenspannung des ersten Transistors (Tr1).

5. Schaltung nach Anspruch 2, dadurch gekennzeichnet, daß ein zweiter MOS Transistor (Q2) zwischen dem ersten Schaltungsanschluß (V<sub>cc</sub>) und dem einen Anschluß der ersten Kapazität geschaltet ist, um parallel mit dem ersten Transistor zu leiten, daß das Gate des zweiten Transistors (Q2) mit dem ersten Schaltungsanschluß (V<sub>cc</sub>) verbunden ist, daß ein dritter MOS Transistor (Q3) so angeschlossen ist, daß er zwischen dem ersten Schaltungsanschluß (V<sub>cc</sub>) und dem anderen Anschluß der ersten Kapazität leitet, und außerdem so angeschlossen ist, daß er in Serie mit einem vierten MOS Transistor (Q4) leitet, der zwischen dem anderen Anschluß der ersten Kapazität und dem zweiten Schaltungsanschluß geschaltet ist und zwar in Serie mit einer Stromquelle (I), wobei der zweite Schaltungsanschluß zwischen dem vierten Transistor (Q4) und der Stromquelle (I) geschaltet ist, daß bei Benutzung ein Taktimpuls (φ₁) dem Gate des dritten Transistors (Q3) zugeführt wird und ein anderer Taktimpuls (φ₂) dem Gate des vierten Transistors (Q4) zugeführt wird, wobei diese Taktimpulse nicht Zeit-überlappend sind, daß die Stromquelle (I) mit

einer Spannungsversorgung (V<sub>ss</sub>) verbunden ist und eine dritte Kapazität (C4) zu der Stromquelle parallel geschaltet ist, daß der zweite, dritte und vierte Transistor (Q2, Q3, Q4) für Anreicherungsbetrieb ausgelegt sind und daß beim Gebrauch der Schaltung eine Ausgangsspannung (V<sub>out</sub>) am zweiten Schaltungsanschluß ansteht, wenn die Werte der Eingangsspannung (V<sub>in</sub>) größer sind als die Spannung am ersten Schaltungsanschluß (V<sub>cc</sub>) plus der Schwellenspannung des ersten Transistors, wogegen keine Ausgangsspannung (V<sub>out</sub>) an dem zweiten Schaltungsanschluß ansteht, wenn die Werte für die Eingangsspannung (V<sub>in</sub>) geringer sind als die Spannung am ersten Schaltungsanschluß (V<sub>cc</sub>) plus der Schwellenspannung des ersten Transistors.

6. Schaltung nach Anspruch 2, unter Verwendung erster, zweiter und dritter Taktsignale (φ'₃, φ'₂, φ'₁), dadurch gekennzeichnet, daß ein fünfter MOS Transistor (Q6) zwischen dem ersten Schaltungsanschluß (V<sub>cc</sub>) und dem einem Anschluß der Kapazität angeschlossen ist und parallel zu dem ersten Transistor leitet, daß der andere Anschluß der Kapazität über die Source-Drain-Leitung eines sechsten MOS Transistor (Q9) mit dem zweiten Schaltungsanschluß verbunden ist, wobei das Gate des sechsten Transistors mit dem Gate des fünften Transistors (Q6) verbunden ist und bei Benutzung der Schaltung das erste Taktsignal (φ'₃) den Gates des fünften und sechsten Transistors zugeführt wird, wobei der zweite Schaltungsanschluß mit einer Spannungsversorgung (V<sub>ss</sub>) verbunden ist, und zwar über die Source-Drain-Leitung eines siebten MOS Transistors (Q10), daß achte und neunte MOS Transistoren (Q7, Q8) in Serie zwischen dem ersten Schaltungsanschluß (V<sub>cc</sub>) und der Spannungsversorgung (V<sub>ss</sub>) angeschlossen sind, daß der andere Anschluß der ersten Kapazität an die Verbindung zwischen dem achten und neunten Transistor (Q7, Q8) angeschlossen ist, daß das zweite Taktsignal (φ'₂) den Gates des siebten und achten Transistors (Q10, Q7) zugeführt wird, daß das dritte Taktsignal (φ'₁) dem Gate des neunten Transistors (Q8) zugeführt wird, daß der fünfte Transistor (Q6) ein Verarmungs-Transistor ist, während der siebte, achte und neunte Transistor (Q10, Q7, Q8) Anreicherungstransistoren sind, daß die Taktsignale derart sind, daß die Spannung am zweiten Schaltungsanschluß null ist während einer Ausgangsperiode (P'3), korrespondierend mit einem ersten Taktsignal-Impuls, wenn während der vorherigen Abfühlperiode (P'2), die mit einem zweiten Taktsignal-Impuls korrespondiert, die Eingangsspannung (V<sub>in</sub>) kleiner war als die Spannung am ersten Schaltungsanschluß (V<sub>cc</sub>) plus der Schwellenspannung des ersten Transistors, wogegen die oben genannten Spannung größer als null ist während einer Ausgangsperiode (P'3), wenn während der vorausgehenden Abfühlperiode (P'2) die Eingangsspannung (V<sub>in</sub>) größer war als die Spannung am ersten Schaltungsanschluß (V<sub>cc</sub>) plus der Schwellenspannung des ersten Transistors.

7. Schaltung nach einem der vorhergehenden Ansprüche und verkörpert in einer integrierten Schaltung, bei der der erste Schaltungsanschluß mit dem $V_{cc}$-Stromleiter korrespondiert.

8. Schaltung nach Anspruch 7, in Verbindung mit Anspruch 5 oder 6, dadurch gekennzeichnet, daß die Spannungsversorgung mit dem $V_{ss}$-Stromleiter der integrierten Schaltung korrespondiert.

### Revendications

1. Circuit sensible à une tension, comprenant un premier condensateur (C1) dont une première borne est connectée à une première borne du circuit ($V_{cc}$) par l'intermédiaire du circuit source-drain d'un premier transistor à effet de champ à grille isolée (Tr1) et dont l'autre borne est connectée à une seconde borne du circuit (T1), caractérisé en ce que, pendant l'utilisation, une tension d'entrée ($V_{in}$) destinée à être comparée à une tension appliquée à la grille (G) du premier transistor (Tr1), l'impédance disponible à la seconde borne du circuit (T1) variant selon que la tension d'entrée ($V_{in}$) est supérieure ou inférieure à la tension appliquée à la première borne du circuit ($V_{cc}$).

2. Circuit selon la revendication 1, caractérisé en ce que la premier transistor (Tr1) est un transistor à effet de champ (MOS) travaillant en mode d'enrichisement dont le drain (D) est connecté à la première borne du circuit ($V_{cc}$).

3. Circuit selon la revendication 2, caractérisé, en ce que, pendant l'utilisation, un signal en courant alternatif est appliqué à l'autre borne du condensateur, le circuit comprenant aussi un dispositif détecteur destiné à déterminer si l'impédance disponible à la seconde borne du circuit a une faible valeur correspondant au fait que la tension d'entrée ($V_{in}$) est supérieure à la tension appliquée à la première borne du circuit ($V_{cc}$) augmentée de la tension de seuil du premier transistor (Tr1) ou une valeur supérieure à la faible valeur correspondant au fait que la tension d'entrée ($V_{in}$) est inférieure à la tension appliquée à la première borne du circuit ($V_{cc}$) augmentée de la tension de seuil du premier transistor (Tr1).

4. Circuit selon la revendication 3, caractérisé en ce que le signal en courant alternatif est appliqué à l'autre borne du premier condensateur par l'intermédiaire d'une résistance, dans lequel un second condensateur (C2) est connecté entre la seconde borne du circuit (T1) et la masse, et un détecteur de signaux alternatifs est connecté à la seconde borne du circuit (T1), l'amplitude du signal appliqué au détecteur de signaux alternatifs étant supérieure pour des valeurs de la tension d'entrée inférieures à la tension appliquée à la première borne du circuit ($V_{cc}$) augmentée de la tension de seuil du premier transistor (Tr1), et inférieure à l'amplitude du signal pour des valeurs de tension d'entrée supérieures à la tension appliquée à la première borne du circuit augmentée de la tension de seuil du premier transistor (Tr1).

5. Circuit selon la revendication 2, caractérisé en ce qu'un second transistor MOS (Q2) est connecté de manière qu'il conduise en parallèle avec le premier transistor, entre la première borne du circuit ($V_{cc}$) et la première borne du premier condensateur, la grille du second transistor (Q2) étant connectée à la première borne du circuit ($V_{cc}$), en ce qu'un troisième transistor MOS (Q3) est connecté afin qu'il conduise entre la première borne du circuit ($V_{cc}$) et l'autre borne du premier condensateur et est connecté afin qu'il conduise en série avec un quatrième transistor MOS (Q4) connecté entre l'autre borne du premier condensateur et la seconde borne du circuit, en série avec une source de courant (I), la seconde borne du circuit étant connectée entre la quatrième transistor (Q4) et la source de courant (I), en ce que, pendant l'utilisation, une première impulsion d'horloge ($\phi_1$) est appliquée à la grille du troisième transistor (Q3) et une autre impulsion d'horloge ($\phi_2$) est appliquée à la grille du quatrième transistor (Q4), les impulsions d'horloge ne se recouvrant pas au cours du temps, en ce que la source de courant (I) est connectée à une alimentation en tension ($V_{ss}$) et un troisième condensateur (C4) est connecté en parallèle avec la source de courant, en ce que le second, le troisième et le quatrième transistor (Q2, Q3, Q4) sont du type à mode d'enrichissement, et en ce que, pendant l'utilisation du circuit, une tension de sortie ($V_{out}$) à la seconde borne du circuit est présente pour des valeurs de la tension d'entrée ($V_{in}$) supérieures à la tension appliquée à la première borne du circuit ($V_{cc}$) augmentée de la tension de seuil du premier transistor, et aucune tension de sortie ($V_{out}$) n'existe à la seconde borne du circuit pour des valeurs de la tension d'entrée ($V_{in}$) inférieures à la tension appliquée à la première borne du circuit ($V_{cc}$) augmentée de la tension de seuil du premier transistor.

6. Circuit selon la revendication 2 mettant en oeuvre un premier, un second, et un troisième signal d'horloge ($\phi'_3$, $\phi'_2$, $\phi'_1$), caractérisé en ce qu'un cinquième transistor MOS (Q6) est connecté, afin qu'il conduise en parallèle avec le premier transistor, entre la première borne du circuit ($V_{cc}$) et une première borne du condensateur, en ce que l'autre borne du condensateur est connectée à la seconde borne du circuit par l'intermédiaire du circuit source-drain d'un sixième transistor MOS (Q9) dont la grille est connectée à la grille du cinquième transistor (Q6) et, pendant l'utilisation du circuit, le premier signal d'horloge ($\phi'_3$) est appliqué aux grilles du cinquième et du sixième transistor, en ce que la seconde borne du circuit est connectée à une alimentation de tension ($V_{ss}$) par l'intermédiaire du circuit source-drain d'un septième transistor MOS (Q10), en ce qu'un huitième et un neuvième transistor MOS (Q7, Q8) sont connectés en série entre la première borne du circuit ($V_{cc}$) et l'alimentation de tension ($V_{ss}$), en ce que l'autre borne du premier condensateur est connectée à la connexion du huitième et du neuvième transistor (Q7, Q8), en ce que le second signal d'horloge ($\phi'_2$) est appliqué aux grilles du septième et du huitième transistor (Q10, Q7), en ce que le troisième signal d'horloge (φ'$_1$) est appliqué à la grille du neuvième transistor (Q8), le cinquième transistor (Q6) étant du type travaillant en mode d'appauvrissement et le septième, le huitième et le neuvième transistor (Q10, Q7, Q8) étant du type travaillant en mode d'enrichissement, les signaux d'horloge étant tels que la tension à la seconde borne du circuit est égale à zéro pendant une période de sortie (P'3) qui correspond à une première impulsion de signal d'horloge lorsque, pendant la période précédente de détection (P'2) correspondant à une seconde impulsion de signal d'horloge, la tension d'entrée (V$_{in}$) était inférieure à la tension appliquée à la première borne du circuit (V$_{cc}$) augmentée de la tension de seuil du premier transistor, et est supérieure à zéro pendant une période de sortie (P'3) lorsque, pendant la période précédente de détection (P'2), la tension d'entrée (V$_{in}$) était supérieure à la tension appliquée à la première borne du circuit (V$_{cc}$) augmentée de la tension de seuil du premier transistor.

7. Circuit selon l'une quelconque des revendications précédentes, réalisé dans un circuit intégré, la première borne du circuit correspondant à la ligne d'alimentation (V$_{cc}$).

8. Circuit selon la revendication 7 lorsqu'elle dépend de la revendication 5 ou de la revendication 6, caractérisé en ce que l'alimentation en tension correspond à la ligne (V$_{ss}$) du circuit intégré.

*Fig.1*

A.C. INPUT

*Fig.2*

VOLTAGE

$V_{in} - V_T$

TIME ——

*Fig.3*

A.C. INPUT

$R_1$

$C_2$

A.C. SIGNAL
DETECTOR

*Fig.4*

OUTPUT ($V_{out}$)

1

Fig.5

Fig.6

Fig.7